# EUROPEAN PATENT APPLICATION

(11) **EP 2 988 303 A1**
(43) Date of publication of application: **24.02.2016**
(21) Application number: 15179355.1
(22) Date of filing: 31.07.2015
(51) Int. Cl.: G11B 5/012, G11B 5/39, G11B 5/48

(54) **MULTIPLE-INPUT-MULTIPLE-OUTPUT SENSOR DESIGNS FOR MAGNETIC APPLICATIONS**

(30) Priority: 21.08.2014 US 201414465748
(71) Applicant: HGST Netherlands B.V., 1101 CM Amsterdam (NL)
(72) Inventor: GAO, Zheng, San Jose, CA 95135 (US); GUAN, Lijie, San Jose, CA 95135 (US); HO, Kuok S., San Jose, CA 95135 (US); SONG, Suping, San Jose, CA 95135 (US); WANG, Shuxia, San Jose, CA 95135 (US)
(74) Representative: Johnson, Richard Alan

(57) **Abstract**

According to one embodiment, a system includes a leading magnetic shield, a first sensor structure above the leading magnetic shield, a first middle magnetic shield above the first sensor structure, a nonmagnetic spacer above the first middle magnetic shield, a second middle magnetic shield above the nonmagnetic spacer, a second sensor structure above the second middle magnetic shield, and a trailing magnetic shield above the second sensor structure. Other systems, methods, and computer program products are described in additional embodiments.

## Description

### FIELD OF THE INVENTION

The present invention relates to data storage systems, and more particularly, this invention relates to multiple-input-multiple-output (MIMO) heads having sensor structures with a reduced read gap.

### BACKGROUND

The heart of a computer is a magnetic hard disk drive (HDD) which typically includes a rotating magnetic disk, a slider that has read and write heads, a suspension arm above the rotating disk and an actuator arm that swings the suspension arm to place the read and/or write heads over selected circular tracks on the rotating disk. The suspension arm biases the slider into contact with the surface of the disk when the disk is not rotating but, when the disk rotates, air is swirled by the rotating disk adjacent an air bearing surface (ABS) of the slider causing the slider to ride on an air bearing a slight distance from the surface of the rotating disk. When the slider rides on the air bearing the write and read heads are employed for writing magnetic impressions to and reading magnetic signal fields from the rotating disk. The read and write heads are connected to processing circuitry that operates according to a computer program to implement the writing and reading functions.

The read head typically utilizes a spin valve sensor, also referred to as a giant magnetoresistive (GMR) sensor. The sensor at the ABS typically includes a barrier layer sandwiched between a pinned layer and a free layer, and an antiferromagnetic layer for pinning the magnetization of the pinned layer. The magnetization of the pinned layer is pinned perpendicular to the ABS and the magnetic moment of the free layer is located parallel to the ABS, but free to rotate in response to external magnetic fields.

The volume of information processing in the information age is increasing rapidly. In particular, it is desired that HDDs be able to store more information in their limited area and volume. A technical approach to this desire is to increase the capacity by increasing the recording density of the HDD. To achieve higher recording density, further miniaturization of recorded magnetic clusters is effective, which in turn typically requires the design of smaller and smaller components. The further miniaturization of the various components, however, presents its own set of challenges and obstacles.

The need for increasing the recording density of the HDD is pushing researchers to develop data recording systems that can read and record progressively smaller bit lengths in order to increase the density of data recorded on a magnetic medium. This has led to a push to decrease the gap thickness of a read head such as a GMR head. However, the amount by which such gap thickness can be decreased has been limited by physical limitations of sensors and also by the limitations of currently available manufacturing methods.

Therefore, there is a need for improved magnetic heads and methods of manufacture that enabling reduction of the read gap thickness while preserving the reliability of the magnetic head.

### SUMMARY

A system, according to one embodiment, includes a leading magnetic shield, a first sensor structure above the leading magnetic shield, a first middle magnetic shield above the first sensor structure, a nonmagnetic spacer above the first middle magnetic shield, a second middle magnetic shield above the nonmagnetic spacer, a second sensor structure above the second middle magnetic shield, and a trailing magnetic shield above the second sensor structure.

A system, according to another embodiment, includes a first scissor sensor structure above a leading magnetic shield, a first bias structure behind the first scissor sensor structure, a second scissor sensor structure above the first scissor sensor, and a second bias structure behind the second scissor sensor structure.

Any of these embodiments may be implemented in a magnetic data storage system such as a disk drive system, which may include a magnetic head, a drive mechanism for passing a magnetic medium (e.g., hard disk) over the magnetic head, and a controller electrically coupled to the magnetic head.

Other aspects and advantages of the present invention will become apparent from the following detailed description, which, when taken in conjunction with the drawings, illustrate by way of example the principles of the invention.

### BRIEF DESCRIPTION OF THE DRAWINGS

For a fuller understanding of the nature and advantages of the present invention, as well as the preferred mode of use, reference should be made to the following detailed description read in conjunction with the accompanying drawings.
FIG. 1 is a simplified drawing of a magnetic recording disk drive system.
FIG. **2A** is a schematic representation in section of a recording medium utilizing a longitudinal recording format.
FIG. **2B** is a schematic representation of a conventional magnetic recording head and recording medium combination for longitudinal recording as in FIG. **2A****.**
FIG. **2C** is a magnetic recording medium utilizing a perpendicular recording format.
FIG. **2D** is a schematic representation of a recording head and recording medium combination for perpendicular recording on one side.
FIG. **2E** is a schematic representation of a recording apparatus adapted for recording separately on both sides of the medium.
FIG. **3A** is a cross-sectional view of one particular embodiment of a perpendicular magnetic head with helical coils.
FIG. **3B** is a cross-sectional view of one particular embodiment of a piggyback magnetic head with helical coils.
FIG. **4A** is a cross-sectional view of one particular embodiment of a perpendicular magnetic head with looped coils.
FIG. **4B** is a cross-sectional view of one particular embodiment of a piggyback magnetic head with looped coils.
FIG. **5** is a partial cross-sectional perspective view of a system according to one embodiment.
FIG. **6** is a partial cross-sectional perspective view of a system according to one embodiment.
FIG. **7A** is a partial cross-sectional perspective view of systems according to one embodiment.
FIG. **7B** is a detailed view of the embodiment of FIG. **7A** taken from circle **7B.**
FIG. **7C** is a partial cross-sectional perspective view of a system according to one embodiment.

### DETAILED DESCRIPTION

The following description is made for the purpose of illustrating the general principles of the present invention and is not meant to limit the inventive concepts claimed herein. Further, particular features described herein can be used in combination with other described features in each of the various possible combinations and permutations.

Unless otherwise specifically defined herein, all terms are to be given their broadest possible interpretation including meanings implied from the specification as well as meanings understood by those skilled in the art and/or as defined in dictionaries, treatises, etc.

It must also be noted that, as used in the specification and the appended claims, the singular forms "a," "an" and "the" include plural referents unless otherwise specified. Furthermore, as used herein, the term "about" with reference to some stated value refers to the stated value ± 10% of said value.

The following description discloses several preferred embodiments of disk-based storage systems and/or related systems and methods, as well as operation and/or component parts thereof. Various embodiments described herein include MIMO heads having sensor structures with a desirably reduced read gap, as will be described in further detail below.

In one general embodiment, a system includes a leading magnetic shield, a first sensor structure above the leading magnetic shield, a first middle magnetic shield above the first sensor structure, a nonmagnetic spacer above the first middle magnetic shield, a second middle magnetic shield above the nonmagnetic spacer, a second sensor structure above the second middle magnetic shield, and a trailing magnetic shield above the second sensor structure.

In one general embodiment, a system includes a first scissor sensor structure above a leading magnetic shield, a first bias structure behind the first scissor sensor structure, a second scissor sensor structure above the first scissor sensor, and a second bias structure behind the second scissor sensor structure.

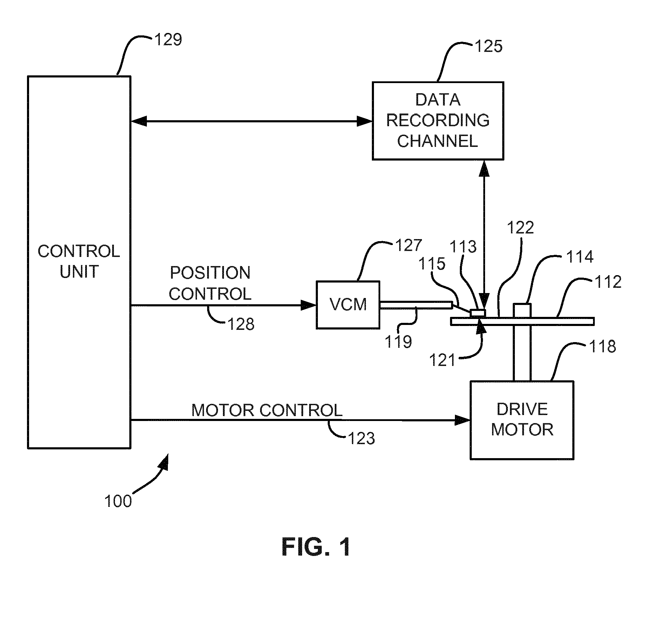

Referring now to FIG. **1****,** there is shown a disk drive **100** in accordance with one embodiment of the present invention. As shown in FIG. **1****,** at least one rotatable magnetic medium (e.g., magnetic disk) **112** is supported on a spindle **114** and rotated by a drive mechanism, which may include a disk drive motor **118.** The magnetic recording on each disk is typically in the form of an annular pattern of concentric data tracks (not shown) on the disk **112.** Thus, the disk drive motor **118** preferably passes the magnetic disk **112** over the magnetic read/write portions **121,** described immediately below.

At least one slider **113** is positioned near the disk **112,** each slider **113** supporting one or more magnetic read/write portions **121,** e.g., of a magnetic head according to any of the approaches described and/or suggested herein. As the disk rotates, slider **113** is moved radially in and out over disk surface **122** so that portions **121** may access different tracks of the disk where desired data are recorded and/or to be written. Each slider **113** is attached to an actuator arm **119** by means of a suspension **115.** The suspension **115** provides a slight spring force which biases slider **113** against the disk surface **122.** Each actuator arm **119** is attached to an actuator **127.** The actuator **127** as shown in FIG. **1** may be a voice coil motor (VCM). The VCM comprises a coil movable within a fixed magnetic field, the direction and speed of the coil movements being controlled by the motor current signals supplied by controller 129.

During operation of the disk storage system, the rotation of disk **112** generates an air bearing between slider **113** and disk surface **122** which exerts an upward force or lift on the slider. The air bearing thus counter-balances the slight spring force of suspension **115** and supports slider **113** off and slightly above the disk surface by a small, substantially constant spacing during normal operation. Note that in some embodiments, the slider **113** may slide along the disk surface **122.**

The various components of the disk storage system are controlled in operation by control signals generated by controller **129,** such as access control signals and internal clock signals. Typically, control unit **129** comprises logic control circuits, storage (e.g., memory), and a microprocessor. In a preferred approach, the control unit **129** is electrically coupled (e.g., via wire, cable, line, etc.) to the one or more magnetic read/write portions **121,** for controlling operation thereof. The control unit **129** generates control signals to control various system operations such as drive motor control signals on line **123** and head position and seek control signals on line **128.** The control signals on line **128** provide the desired current profiles to optimally move and position slider **113** to the desired data track on disk **112.** Read and write signals are communicated to and from read/write portions **121** by way of recording **channel 125.**

The above description of a typical magnetic disk storage system, and the accompanying illustration of FIG. **1** is for representation purposes only. It should be apparent that disk storage systems may contain a large number of disks and actuators, and each actuator may support a number of sliders.

An interface may also be provided for communication between the disk drive and a host (integral or external) to send and receive the data and for controlling the operation of the disk drive and communicating the status of the disk drive to the host, as will be understood by those of skill in the art.

In a typical head, an inductive write portion includes a coil layer embedded in one or more insulation layers (insulation stack), the insulation stack being located between first and second pole piece layers. A gap is formed between the first and second pole piece layers of the write portion by a gap layer at or near a media facing surface of the head (sometimes referred to as an ABS in a disk drive). The pole piece layers may be connected at a back gap. Currents are conducted through the coil layer, which produce magnetic fields in the pole pieces. The magnetic fields fringe across the gap at the media facing surface for the purpose of writing bits of magnetic field information in tracks on moving media, such as in circular tracks on a rotating magnetic disk.

The second pole piece layer has a pole tip portion which extends from the media facing surface to a flare point and a yoke portion which extends from the flare point to the back gap. The flare point is where the second pole piece begins to widen (flare) to form the yoke. The placement of the flare point directly affects the magnitude of the magnetic field produced to write information on the recording medium.

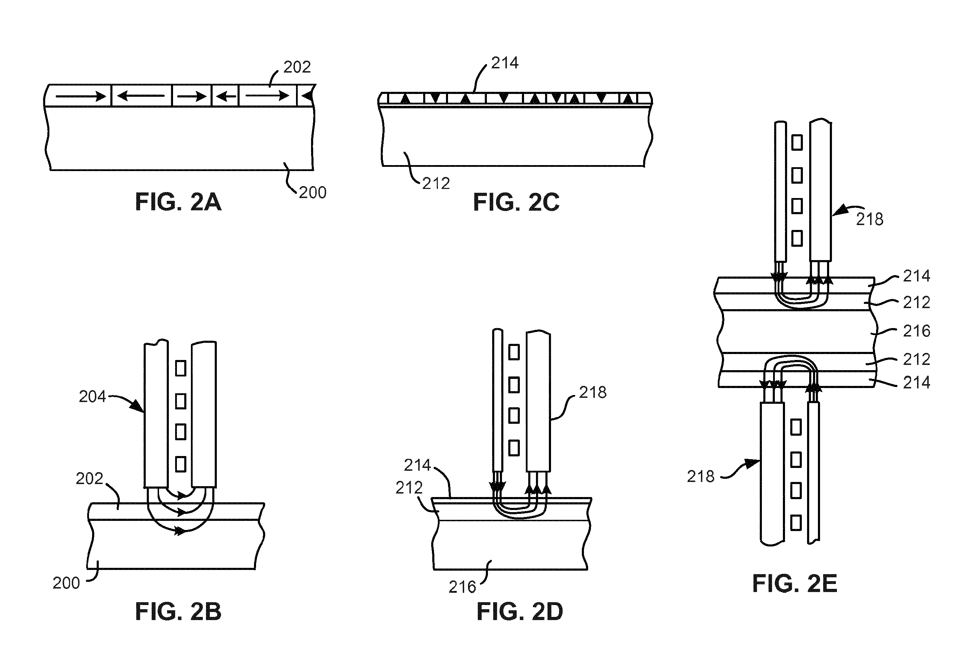

FIG. **2A** illustrates, schematically, a conventional recording medium such as used with magnetic disc recording systems, such as that shown in FIG. **1****.** This medium is utilized for recording magnetic impulses in or parallel to the plane of the medium itself. The recording medium, a recording disc in this instance, comprises basically a supporting substrate **200** of a suitable non-magnetic material such as aluminum or glass, with an overlying coating **202** of a suitable and conventional magnetic layer.

FIG. **2B** shows the operative relationship between a conventional recording/playback head **204,** which may preferably be a thin film head, and a conventional recording medium, such as that of FIG. **2A****.**

FIG. **2C** illustrates, schematically, the orientation of magnetic impulses substantially perpendicular to the surface of a recording medium as used with magnetic disc recording systems, such as that shown in FIG. **1****.** For such perpendicular recording the medium typically includes an under layer **212** of a material having a high magnetic permeability. This under layer **212** is then provided with an overlying coating **214** of magnetic material preferably having a high coercivity relative to the under layer **212.**

FIG. **2D** illustrates the operative relationship between a perpendicular head **218** and a recording medium. The recording medium illustrated in FIG. **2D** includes both the high permeability under layer **212** and the overlying coating **214** of magnetic material described with respect to FIG. **2C** above. However, both of these layers **212** and **214** are shown applied to a suitable substrate **216.** Typically there is also an additional layer (not shown) called an "exchange-break" layer or "interlayer" between layers **212** and **214.**

In this structure, the magnetic lines of flux extending between the poles of the perpendicular head **218** loop into and out of the overlying coating **214** of the recording medium with the high permeability under layer **212** of the recording medium causing the lines of flux to pass through the overlying coating **214** in a direction generally perpendicular to the surface of the medium to record information in the overlying coating **214** of magnetic material preferably having a high coercivity relative to the under layer **212** in the form of magnetic impulses having their axes of magnetization substantially perpendicular to the surface of the medium. The flux is channeled by the soft underlying coating **212** back to the return layer (P1) of the head **218.**

FIG. **2E** illustrates a similar structure in which the substrate **216** carries the layers **212** and **214** on each of its two opposed sides, with suitable recording heads **218** positioned adjacent the outer surface of the magnetic coating **214** on each side of the medium, allowing for recording on each side of the medium.

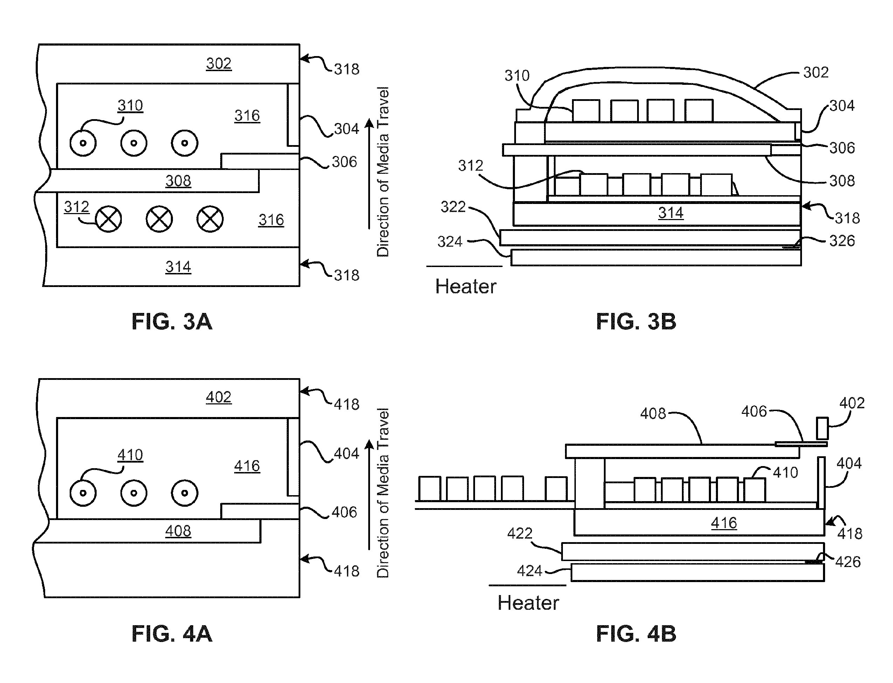

FIG. **3A** is a cross-sectional view of a perpendicular magnetic head. In FIG. **3A****,** helical coils **310** and **312** are used to create magnetic flux in the stitch pole **308,** which then delivers that flux to the main pole **306.** Coils **310** indicate coils extending out from the page, while coils **312** indicate coils extending into the page. Stitch pole **308** may be recessed from the media facing surface **318.** Insulation **316** surrounds the coils and may provide support for some of the elements. The direction of the media travel, as indicated by the arrow to the right of the structure, moves the media past the lower return pole **314** first, then past the stitch pole **308,** main pole 306, trailing shield **304** which may be connected to the wrap around shield (not shown), and finally past the upper return pole **302.** Each of these components may have a portion in contact with the media facing surface **318.** The media facing surface **318** is indicated across the right side of the structure.

Perpendicular writing is achieved by forcing flux through the stitch pole **308** into the main pole **306** and then to the surface of the disk positioned towards the media facing surface **318.**

FIG. **3B** illustrates a piggyback magnetic head having similar features to the head of FIG. **3A****.** Two shields **304, 314** flank the stitch pole **308** and main pole 306. Also sensor shields **322, 324** are shown. The sensor **326** is typically positioned between the sensor shields **322, 324.**

FIG. **4A** is a schematic diagram of one embodiment which uses looped coils **410,** sometimes referred to as a pancake configuration, to provide flux to the stitch pole **408.** The stitch pole then provides this flux to the main pole **406.** In this orientation, the lower return pole is optional. Insulation **416** surrounds the coils **410,** and may provide support for the stitch pole **408** and main pole **406.** The stitch pole may be recessed from the media facing surface **418.** The direction of the media travel, as indicated by the arrow to the right of the structure, moves the media past the stitch pole **408,** main pole **406,** trailing shield **404** which may be connected to the wrap around shield (not shown), and finally past the upper return pole **402** (all of which may or may not have a portion in contact with the media facing surface **418).** The media facing surface **418** is indicated across the right side of the structure. The trailing shield **404** may be in contact with the main pole **406** in some embodiments.

FIG. **4B** illustrates another type of piggyback magnetic head having similar features to the head of FIG. **4A** including a looped coil **410,** which wraps around to form a pancake coil. Also, sensor shields **422, 424** are shown. The sensor 426 is typically positioned between the sensor shields **422, 424.**

In FIGS. **3B** and **4B****,** an optional heater is shown away from the media facing surface of the magnetic head. A heater **(Heater)** may also be included in the magnetic heads shown in FIGS. **3A** and **4A****.** The position of this heater may vary based on design parameters such as where the protrusion is desired, coefficients of thermal expansion of the surrounding layers, etc.

Except as otherwise described herein, the various components of the structures of FIGS. **3A-4B** may be of conventional materials and design, as would be understood by one skilled in the art.

As previously mentioned, the desire for increasing the recording density of HDDs is pushing researchers to develop data recording systems that can read and record progressively smaller bit lengths along the track direction in order to increase the density of data recorded on a magnetic medium. This has led to attempts to decrease the gap thickness of a read head (also referred to herein as the "read gap"). However, in conventional products, the amount by which such gap thickness can be decreased has been limited by physical limitations of sensors and also by the limitations of currently available manufacturing methods.

In sharp contrast to such conventional shortcomings, various embodiments presented herein include improved MIMO sensor structures desirably having a reduced read gap, as will be described in further detail below.

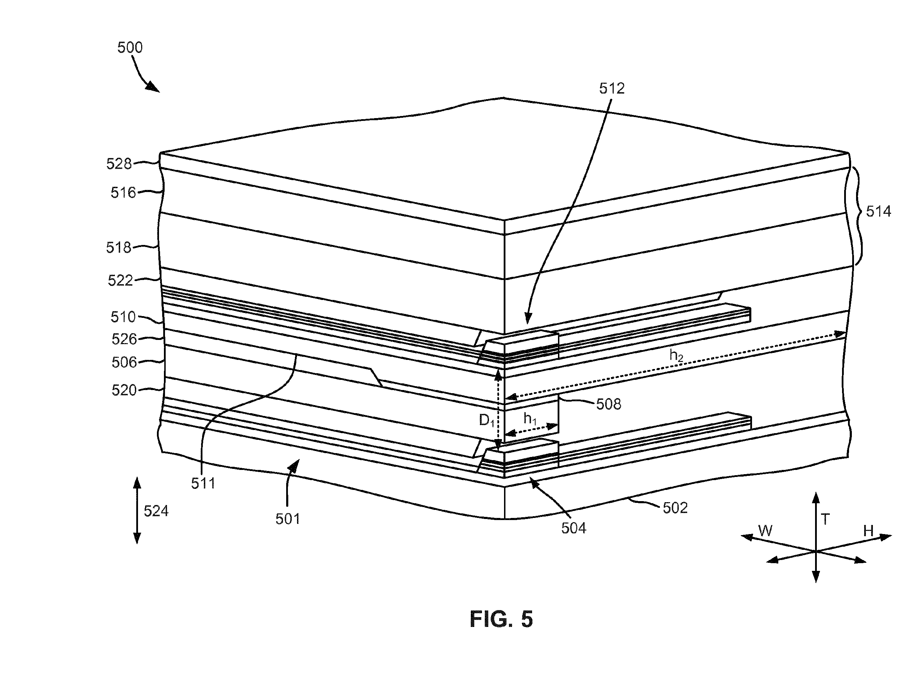

Looking to FIG. **5****,** a system **500** having a MIMO sensor structure is illustrated according to one embodiment. Particularly, the depiction is a partial cross-sectional view showing the media facing surface **501** of the system **500** oriented along a plane extending along the width direction **W and** the thickness direction **T.** The cross-section is taken along a plane extending along the height direction **H** and the thickness direction **T.**

As an option, the present system **500** may be implemented in conjunction with features from any other embodiment listed herein, such as those described with reference to the other FIGS. Of course, however, such system **500** and others presented herein may be used in various applications and/or in permutations which may or may not be specifically described in the illustrative embodiments listed herein. Further, the system **500** presented herein may be used in any desired environment. Thus FIG. **5** (and the other FIGS.) should be deemed to include any and all possible permutations.

Referring now to FIG. **5****,** system **500** includes leading magnetic shield **502** and first sensor structure **504** positioned above the leading magnetic shield **502.** Moreover, a first middle magnetic shield **506** is positioned above the first sensor structure **504,** and a nonmagnetic spacer **508** is positioned above the first middle magnetic shield **506.** Further still, a second middle magnetic shield **510** is positioned above nonmagnetic spacer **508.**

System **500** additionally includes a trailing magnetic shield **514** which is separated from the second middle magnetic shield **510** by a second sensor structure **512** which is positioned between the two. Additionally, as illustrated in the present embodiment, the trailing magnetic shield **514** may include a top portion **516** and a bottom portion **518.**

According to different approaches, leading magnetic shield **502,** and/or trailing magnetic shield **514** (e.g., both top and bottom portions **516, 518)** may include one or more magnetically permeable material, e.g., such as Ni, Co and Fe alloys, but is in no way limited thereto. Moreover, leading and trailing magnetic shields **502, 514** may include the same, similar, or different materials, compositions, dimensions, etc., depending on the desired embodiment.

As illustrated in FIG. **5****,** second middle magnetic shield **510** has a longer height **h₂** than the height **h₁** of the first middle magnetic shield **506** measured in a direction perpendicular to the media facing surface **501** of system **500.** However, in other approaches, the second middle magnetic shield **510** may have a height that is the same or shorter than that of the first middle magnetic shield **506,** depending on the desired embodiment.

In further approaches, first middle magnetic shield **506** and/or second middle magnetic shield **510** may include any magnetic shield described immediately above with reference to leading and trailing magnetic shields **502, 514,** or any other magnetic shield described herein. Moreover, first and second middle magnetic shields **506, 510** may include the same, similar, or different materials, compositions, dimensions, etc., depending on the desired embodiment. According to an exemplary embodiment, the first middle magnetic shield **506** may include NiFe. Furthermore, according to preferred approaches, second middle magnetic shield **510** includes one or more material having a high magnetic moment, e.g., at least higher than the magnetic moment of the first middle magnetic shield **506.**

Referring still to FIG. **5****,** first and second sensor structures **504, 512** are preferably configured to detect magnetic transitions of a magnetic medium such as a magnetic disk. Moreover, it is desirable that first and second sensor structures **504, 512** include a tunneling magnetoresistance (TMR) sensor, but are in no way limited thereto. Depending on the desired embodiment, the first sensor structure **504** and/or second sensor structure **512** may include any type of current in plane (CIP) or current perpendicular to plane (CPP) sensor, e.g., a giant magnetoresistive (GMR) sensor, Anisotropic magnetoresistance (AMR) sensor, scissor sensor, etc., or any other type of sensor structure which would be apparent to one skilled in the art upon reading the present description.

In preferred embodiments, the first and second sensor structures **504, 512** include the same type of sensor. For example, if the first sensor structure **504** includes a TMR sensor, it is preferred that the second sensor structure **512** includes a TMR sensor as well. This allows for the system **500** to perform MIMO operations whereby the signal from both sensor structures is utilized while reading data from a given medium. Moreover, in other approaches, data from multiple data tracks may be read and processed concurrently when using sensor structures having the same type of sensor. However, first and second sensor structures **504, 512** are in no way intended to be limited to being the same type of sensor. In other embodiments, the first and second sensor structures **504, 512** may include similar (but not the same) or different types of sensors, depending on the desired embodiment.

System **500** further includes side magnetic shields **520, 522** positioned on opposite sides of the first sensor structure in a direction perpendicular to an intended direction **524** of media travel relative thereto. Depending on the desired embodiment, one or both of the side magnetic shields **520, 522** may include any of the same, similar, or different materials, compositions, dimensions, etc., as any of the magnetic shield layers described herein.

A pinning layer **526** is positioned between (e.g., adjacent) each of the side magnetic shields **520, 522.** The pinning layer **526** may be used for pinning a magnetic orientation of an associated one or more of the side magnetic shields **520, 522.** It follows that in some approaches, the pinning layer **526** may be an antiferromagnetic (AFM) layer, whereby the pinning layer **526** may include any materials, compositions, dimensions, etc. that would be apparent to one skilled in the art upon reading the present description. For example, the pinning layer **526** may include PtMn, IrMn, etc.

Looking still to system **500** of FIG. **5****,** a lower surface of the second middle magnetic shield **510** has a cutout **511** for accommodating the pinning layer **526.** This results in having only a portion of the pinning layer's **526** thickness contribute to the overall distance separating the first and second sensor structures **504, 512** in an intended direction **524** of media travel relative thereto. Thus, the cutout of the second middle magnetic shield **510** allows for the distance separating the leading and trailing magnetic shields to be reduced, thereby resulting in an improved (shortened) read gap. As previously mentioned, the reduction of the read gap for a given embodiment is desired, particularly for increasing the recording density of HDDs.

Moreover, the cutout **511** of the second middle magnetic shield **510** allows for a reduced spacing between the first and second sensor structures **504, 512.** As a result of the design of the components of system **500,** the distance **D₁** separating the first and second sensor structures **504, 512** in an intended direction **524** of media travel relative thereto may be less than about 60 nm, more preferably less than about 50 nm, but may be higher or lower depending on the desired embodiment. Thus, various embodiments described herein are able to achieve a 50% or greater reduction in the spacing between sensors compared to conventional MIMO products which have sensors separated by 120 nm or more.

In other approaches, an insulating layer (not shown) may be positioned between the first and second middle magnetic shields **506, 510,** e.g., for electrically isolating the sensors. Thus, in preferred approaches, the insulating layer includes electrically insulating materials such as alumina, plastic, rubber, glass, etc., or any other electrically insulating material which would be apparent to one skilled in the art upon reading the present description. By electrically insulating the first and second middle magnetic shields **506, 510,** system **500** gains the ability to provide two independent signals as each of the first and second sensor structures **504, 512** and corresponding shield layers are electrically isolated from each other. This may be useful, for example, where current in plane (CIP) sensors are used and/or in approaches where independent signals are desired. In some approaches, the nonmagnetic spacer **508** may serve as at least a portion of an electrically insulating layer, e.g., for electrically isolating the first and second middle magnetic shields **506, 510.** However, in other approaches, nonmagnetic spacer **508** may include Ru, Ta, etc., or any other nonmagnetic material which would be apparent to one skilled in the art upon reading the present description.

It follows that, in some embodiments one or both of the first and second sensor structures **504, 512** may be electrically coupled to a controller, e.g., which controls operation of the sensor structures **504, 512.** Thus, each of the first and second sensor structures **504, 512** may perform independent read operations concurrently with each other. In such approaches having a controller electrically coupled to one or both of the first and second sensor structures **504, 512,** the controller may include any type of controller which would be apparent to one skilled in the art upon reading the present description, and may incorporate any of the approaches described and/or suggested above, e.g., see control unit **129** of FIG. **1****.**

Note that in the embodiment of FIG. 5 and other embodiments, additional layers of known type may be present. Such layers may include, but are not limited to seed layers, insulating layers, nonmagnetic layers, etc.

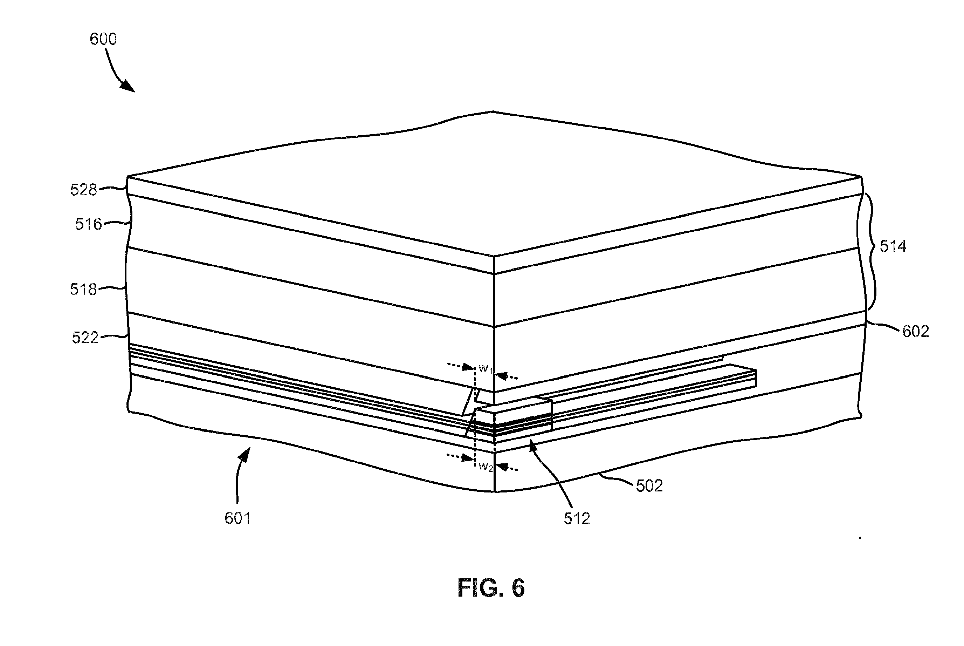

Further still, although not visible in the present illustration of FIG. 5, in some embodiments, system **500** may include a notch layer between the second sensor structure **512** and the trailing magnetic shield **514,** e.g., see **602** of FIG. **6****.**

FIG. **6** depicts a system **600** having a notch layer **602,** in accordance with one embodiment. As an option, the present system **600** may be implemented in conjunction with features from any other embodiment listed herein, such as those described with reference to the other FIGS., such as FIG. **5****.** Specifically, FIG. **6** illustrates variations of the embodiment of FIG. **5** and accordingly, various components of FIG. **6** have common numbering with those of FIG. **5****.**

Of course, however, such system **600** and others presented herein may be used in various applications and/or in permutations which may or may not be specifically described in the illustrative embodiments listed herein. Further, the system **600** presented herein may be used in any desired environment. Thus FIG. **6** (and the other FIGS.) should be deemed to include any and all possible permutations.

Referring now to FIG. **6****,** system **600** includes a leading magnetic shield **502,** above which is a sensor structure **512** and corresponding side shield **522.** Moreover, a notch layer **602** is positioned above the sensor structure **512.** Furthermore, trailing magnetic shield **514** (e.g., having top and bottom portions **516, 518)** and AFM layer **528** are positioned above the notch layer **602.** Thus, the notch layer **602** is positioned between the sensor structure **512** and the trailing magnetic shield **514.**

In preferred approaches, the notch layer **602** includes a magnetic material, e.g., NiFe. By forming the notch layer **602** using a magnetic material, the notch layer **602** effectively acts as a magnetic extension of the magnetically biased trailing magnetic shield **514.** Thus, the effective read gap, e.g., separation between the leading and trailing magnetic shields **502, 514,** is desirably reduced.

With continued reference to system **600** of FIG. **6****,** the notch layer **602** has a width (2 x **w₁**) at a media facing surface **601** thereof no wider than a width (2 x **w₂**) of the sensor structure **512** at a media facing surface **601** thereof.

Moreover, it should be noted that although the embodiment illustrated in FIG. **6** shows only one sensor structure **512** and corresponding side magnetic shield **522,** as noted above, the notch layer **602** may be implemented in embodiments having more than one sensor structure, e.g., in systems having MIMO functionality as seen in system **500** of FIG. **5****.**

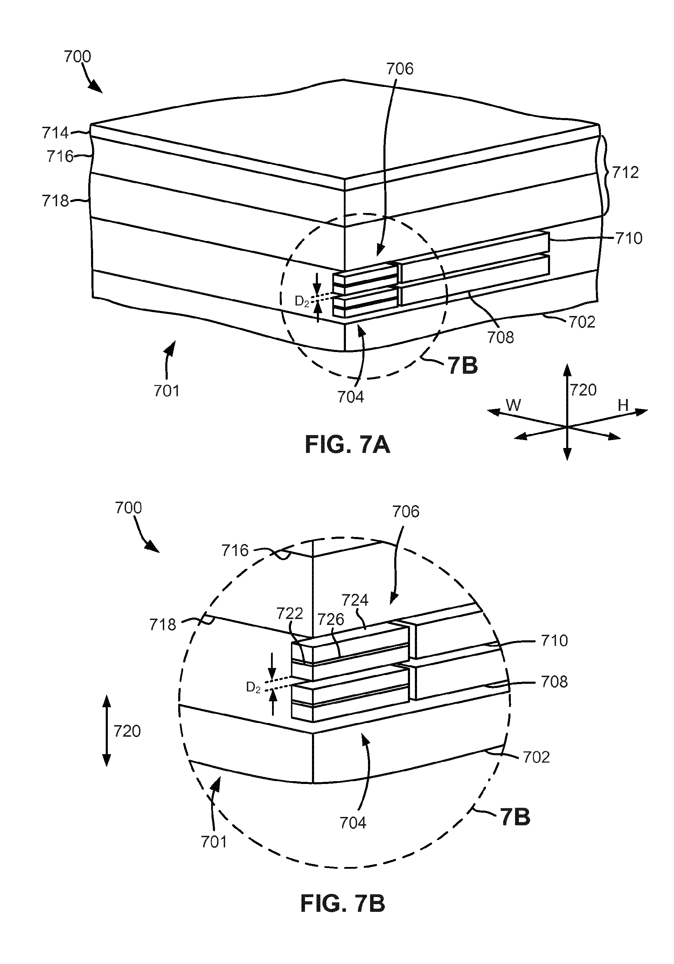

According to different embodiments, any of the approaches described herein may be implemented in systems having scissor sensors. Looking to FIGS. **7A-****7C,** systems **700, 750** having scissor sensors are illustrated according to two embodiments. As an option, the present systems **700, 750** may be implemented in conjunction with features from any other embodiment listed herein, such as those described with reference to the other FIGS., such as FIGS. **5-6****.** Of course, however, such systems **700, 750** and others presented herein may be used in various applications and/or in permutations which may or may not be specifically described in the illustrative embodiments listed herein. Further, the systems **700, 750** presented herein may be used in any desired environment. Thus FIGS. **7A-7C** (and the other

FIGS.) should be deemed to include any and all possible permutations.

In FIGS. **7A**-**7C**, both systems **700, 750** include a leading shield **702,** above which first and second scissor sensor structures **704, 706** and corresponding first and second bias structures **708, 710,** respectively, are positioned. Moreover, trailing magnetic shield **712** and AFM layer **714** are positioned above first and second scissor sensor structures **704, 706.**

As mentioned in other embodiments above, trailing magnetic shield **712** includes a top portion **716** and a bottom portion **718** which may include the same, similar, or different materials, compositions, dimensions, etc., depending on the desired embodiment.

Looking momentarily to FIG. **7B****,** each of the first and second scissor sensor structures **704, 706** may include a first free layer **722** separated from a second free layer **724** by a barrier layer **726.** The barrier layer **726** preferably includes MgO or a conventional tunnel barrier material, but is not limited thereto. Moreover, the first and second free layers **722, 724** may be of conventional construction as would be appreciated by one skilled in the art upon reading the present description.

Furthermore, looking to the first and second bias structures **708, 710,** these bias structures are positioned behind the respective first and second scissor sensor structures **704, 706** along a direction perpendicular to the media facing surface **701.** In other words, the first and second scissor sensor structures **704, 706** are positioned closer to the media facing surface **701** than the first and second bias structures **708, 710** along a direction perpendicular to the media facing surface **701.**

Moreover, as shown, neither system **700, 750** includes side magnetic shields adjacent either of the scissor sensor structures **704, 706.** First and second rear bias structures **708, 710** are able to adequately magnetically bias the scissor sensor structures **704, 706** regardless of the presence of any side magnetic shields. Thus, in various approaches, which are in no way intended to limit the invention, some systems **700, 750** may have no side biasing layers and/or no side magnetic shields positioned in a same plane with either of the scissor sensor structures **704, 706,** said plane being oriented perpendicular to a media facing surface and a direction of tape travel, i.e., along the height-width **(H-W)** plane. However, rear biasing structures, e.g., **708** and **710** of FIG. **7B****,** may be present.

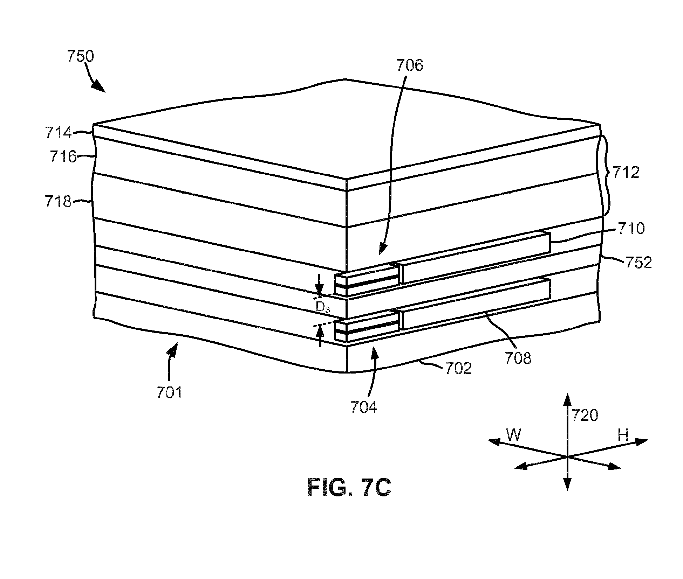

Referring now specifically to FIG. **7C****,** system **750** includes a middle magnetic shield **752** which is positioned between the first and second scissor sensor structures **704, 706.** According to different approaches, middle magnetic shield **752** may include any of the materials, compositions, dimensions, etc. described above, depending on the desired embodiment. In an exemplary embodiment, which is in no way intended to limit the invention, the middle magnetic shield **752** may include NiFe.

As a result of placing the middle magnetic shield **752** between the first and second scissor sensor structures **704, 706,** the distance **D₃** between the first and second scissor sensor structures **704, 706** in an intended direction **720** of media travel relative thereto, may be less than about 60 nm, more preferably less than about 50 nm, but could be higher or lower depending on the desired embodiment.

Alternatively, looking now to FIG. **7A****,** system **700** does not include a middle magnetic shield between the first and second scissor sensor structures **704, 706.** Thus, in one approach, which is in no way intended to limit the invention, it could be said that system **700** may have a proviso that no magnetic shield is positioned between the first and second scissor sensor structures **704, 706.** However, in other approaches, different layers and/or structures may be positioned between the first and second scissor sensor structures **704, 706,** e.g., depending on the desired embodiment.

Compared to distance **D₃** as seen in system **750,** the distance **D₂** of FIG. **7A** between the first and second scissor sensor structures **704, 706** in an intended direction **720** of media travel relative thereto may be less than about 20 nm, but could be higher or lower.

Furthermore, in some embodiments a notch layer may be positioned between the second scissor sensor structure **706** and the trailing magnetic shield **712.** As described above, the notch layer preferably includes a magnetic material, e.g., for effectively achieving a magnetic extension of the magnetically biased trailing magnetic shield **712.** Thus, the effective read gap (the separation between the leading and trailing magnetic shields **702, 712)** is desirably reduced.

It should be noted that methodology presented herein for at least some of the various embodiments may be implemented, in whole or in part, in computer hardware, software, by hand, using specialty equipment, etc. and combinations thereof.

Moreover, any of the structures and/or steps may be implemented using known materials and/or techniques, as would become apparent to one skilled in the art upon reading the present specification.

The inventive concepts disclosed herein have been presented by way of example to illustrate the myriad features thereof in a plurality of illustrative scenarios, embodiments, and/or implementations. It should be appreciated that the concepts generally disclosed are to be considered as modular, and may be implemented in any combination, permutation, or synthesis thereof. In addition, any modification, alteration, or equivalent of the presently disclosed features, functions, and concepts that would be appreciated by a person having ordinary skill in the art upon reading the instant descriptions should also be considered within the scope of this disclosure.

While various embodiments have been described above, it should be understood that they have been presented by way of example only, and not limitation. Thus, the breadth and scope of an embodiment of the present invention should not be limited by any of the above-described exemplary embodiments, but should be defined only in accordance with the following claims, as interpreted using the description and drawings.

## Claims

1. A system, comprising:
a leading magnetic shield;
a first sensor structure above the leading magnetic shield;
a first middle magnetic shield above the first sensor structure;
a nonmagnetic spacer above the first middle magnetic shield;
a second middle magnetic shield above the nonmagnetic spacer;
a second sensor structure above the second middle magnetic shield; and
a trailing magnetic shield above the second sensor structure.

2. The system as recited in claim 1, comprising:
side magnetic shields positioned on opposite sides of the first sensor structure in a direction perpendicular to an intended direction of media travel relative thereto; and
a pinning layer adjacent each of the side magnetic shields for pinning a magnetic orientation of an associated one of the side magnetic shields.

3. The system as recited in claim 2, wherein a lower surface of the second middle magnetic shield has a cutout for accommodating the pinning layer.

4. The system as recited in claim 1, comprising an insulating layer between the first middle magnetic shield and the second middle magnetic shield.

5. The system as recited in claim 1, comprising a notch layer between the second sensor structure and the trailing magnetic shield, the notch layer comprising a magnetic material.

6. The system as recited in claim 5, wherein the notch layer has a width at a media facing surface thereof no wider than the second sensor structure at a media facing surface thereof.

7. The system as recited in claim 1, wherein the second middle magnetic shield has a longer height than the first middle magnetic shield.

8. A system, comprising:
a first scissor sensor structure above a leading magnetic shield;
a first bias structure behind the first scissor sensor structure;
a second scissor sensor structure above the first scissor sensor; and
a second bias structure behind the second scissor sensor structure.

9. The system as recited in claim 1 or 8, wherein a distance between the first and second sensor structures or between the first and second scissor sensor structures in an intended direction of media travel relative thereto is less than about 60 nm, preferably less than 50 nm.

10. The system as recited in claim 8, comprising a middle magnetic shield between the first and second scissor sensor structures.

11. The system as recited in claim 8, with a proviso that no magnetic shield is positioned between the first and second scissor sensor structures.

12. The system as recited in claim 11, wherein a distance between the first and second scissor sensor structures in an intended direction of media travel relative thereto is less than about 20 nm.

13. The system as recited in claim 8, with a proviso that no side biasing layers and/or no side magnetic shields are positioned in a same plane with either of the scissor sensor structures, said plane being oriented perpendicular to a media facing surface and a direction of tape travel.

14. The system as recited in claim 8, comprising a notch layer between the second scissor sensor structure and a trailing magnetic shield, the notch layer comprising a magnetic material.

15. The system as recited in claim 1 or 8, further comprising:
a magnetic medium;
a drive mechanism for passing the magnetic medium over the sensor structures; and
a controller electrically coupled to the sensor structures for controlling operation thereof.
